# EUROPEAN PATENT APPLICATION

(11) **EP 2 154 183 A1**
(43) Date of publication of application: **17.02.2010**
(21) Application number: 09169991.8
(22) Date of filing: 18.09.2006
(51) Int. Cl.: C08J 7/04, H01L 21/312

(54) **Coated substrates and methods for their preparation**

(30) Priority: 05.10.2005 US 723688 P
(62) Divisional of application: 06803778.7
(71) Applicant: Dow Corning Corporation, Midland, MI 48686-0994 (US); Dow Corning Toray Co., Ltd., Tokyo 100-0005 (JP)
(72) Inventor: Albaugh, John, Dean, Midland, MI 48623 (US); Amoko, Masaaki, Chiba 299-0117 (JP); Camilletti, Robert, Charles, Midland, MI 48640 (US); Choi, Dong, Midland, MI 48640 (US); Weidner, William, Bay City, MI 48708 (US); Zambov, Ludmil, Midland, MI 48640 (US)
(74) Representative: Gillard, Richard Edward

(57) **Abstract**

Coated substrates comprising an inorganic barrier coating and an interfacial coating, wherein the interfacial coating comprises a cured product of a silicone resin having silicon-bonded radiation-sensitive groups; and methods of preparing the coated substrates.

## Description

### CROSS-REFERENCE TO RELATED APPLICATIONS

None

### FIELD OF THE INVENTION

The present invention relates to coated substrates and more particularly to coated substrates comprising an inorganic barrier coating and an interfacial coating, wherein the interfacial coating comprises a cured product of a silicone resin having silicon-bonded radiation-sensitive groups. The present invention also relates to methods of preparing the coated substrates.

### BACKGROUND OF THE INVENTION

Barrier coatings play an important role in a wide range of applications including electronic packaging, food packaging, and surface treatment, by protecting sensitive materials from air, moisture, and environmental contaminants. In particular, barrier coatings are frequently applied to polymer substrates to reduce the transmission rates of various gases and liquids through these permeable materials. As a result, such coatings increase the reliability and useful lifespan of many consumer products.

Barrier coatings comprising a single layer of an inorganic material, such as a metal oxide or nitride are known in the art. However, such coatings are often too brittle for use on materials having high thermal expansion, such as polymer substrates. Stresses develop in the barrier layer due to differences in the coefficients of thermal expansion between the substrate and the coating. Thermally induced stresses can cause cracking of the barrier coating, thereby reducing the effectiveness of the coating.

One approach to reducing crack formation in barrier coatings is to deposit an organic coating adjacent to the barrier coating. These multilayer coatings typically comprise alternating layers of inorganic and polymer materials. For example, International Application Publication No. WO 03/016589 A1 to Czeremuszkin et al. discloses a multilayer structure comprising an organic substrate layer, and a mutilayer permeation barrier thereon, the barrier comprising a) a first inorganic coating contacting a surface of the substrate layer, and b) a first organic coating contacting a surface of the inorganic coating.

International Application Publication No. WO 02/091064 A2 to Ziegler, et al. discloses a method of making a flexible barrier material to prevent the passage of water and oxygen to a device which incorporates organic display material, said method comprising the steps of providing a polymer layer; depositing an inorganic barrier layer on the polymer layer by ion-assisted sputtering or evaporation; and depositing a second polymer layer on said inorganic layer, whereby a composite barrier material is provided that can be associated with an electronic display device to prevent degradation of the properties thereof as a result of passage of water and/or oxygen.

U.S. Patent Application Publication No. US2003/0203210 A1 to Graff et al. discloses a multi-layer barrier coating on a flexible substrate comprising alternating polymer and inorganic layers, wherein the layer immediately adjacent to the flexible substrate and the topmost isolation layer may both be inorganic layers.

European Patent Application Publication No. EP1139453 A2 discloses, *inter alia*, a self-light emitting device having an EL element, comprising a film that is made of an inorganic material covering said EL element, and a film that is made of an organic material covering said film made of an inorganic material.

U.S. Patent No. 5,952,778 to Haskal et al. discloses an encapsulated organic light emitting device having an improved protective covering comprising a first layer of passivating metal, a second layer of an inorganic dielectric material and a third layer of polymer.

U.S. Patent No. 6,570,352 B2 to Graff et al. discloses an encapsulated organic light emitting device comprising a substrate; an organic light emitting layer stack adjacent to the substrate; and at least one first barrier stack adjacent to the organic light emitting device, the at least one first barrier stack comprising at least one first barrier layer and at least one first decoupling layer, wherein the at least one first barrier stack encapsulates the organic light emitting device.

Although the aforementioned references disclose coatings having a wide range of barrier properties, there is continued need for coatings having superior resistance to environmental elements, particularly water vapor and oxygen.

### SUMMARY OF THE INVENTION

The present invention is directed to a coated substrate, comprising:
a substrate;
an inorganic barrier coating on the substrate; and
an interfacial coating on the inorganic barrier coating, wherein the interfacial coating comprises a cured product of a silicone resin having the formula (R¹R³₂SiO_{1/2})ₐ (R³₂SiO_{2/2})_{b}(R³SiO_{3/2})_{c}(SiO_{4/2})_{d} (I), wherein each R¹ is independently C₁ to C₁₀ hydrocarbyl, C₁ to C₁₀ halogen-substituted hydrocarbyl, or -OR², wherein R² is C₁ to C₁₀ hydrocarbyl or C₁ to C₁₀ halogen-substituted hydrocarbyl, each R³ is independently R¹, -H, or a radiation-sensitive group, a is from 0 to 0.95, b is from 0 to 0.95, c is from 0 to 1, d is from 0 to 0.9, c+d = 0.1 to 1, and a+b+c+d=1, provided the silicone resin has an average of at least two silicon-bonded radiation-sensitive groups per molecule.

The present invention is also directed to a method of preparing the aforementioned coated substrate, the method comprising the steps of:
forming an inorganic barrier coating on a substrate; and
forming an interfacial coating on the inorganic barrier coating, wherein the interfacial coating comprises a cured product of a silicone resin having the formula (I) above.

The present invention is further directed to a coated substrate, comprising:
a substrate;
an interfacial coating on the substrate, wherein the interfacial coating comprises a cured product of a silicone resin having the formula (I) above; and
an inorganic barrier coating on the interfacial coating.

The present invention is still further directed to a method of preparing the immediately preceding coated substrate, the method comprising the steps of:
forming an interfacial coating on a substrate, wherein the interfacial coating comprises a cured product of a silicone resin having the formula (I) above; and
forming an inorganic barrier coating on the interfacial coating.

The composite inorganic barrier and interfacial coatings of the coated substrate have a low water vapor transmission rate, typically from 1 x 10⁻⁷ to 3 g/m²/day. Also, the coatings have low permeability to oxygen and metal ions, such as copper and aluminum. Further, the coatings can be transparent or nontransparent to light in the visible region of the electromagnetic spectrum. Still further, the coatings have high resistance to cracking and low compressive stress.

The methods of the present invention can be carried out using conventional equipment and techniques, and readily available silicone compositions. For example inorganic barrier coatings can be deposited using chemical vapor deposition techniques and physical vapor deposition techniques. Moreover, interfacial coatings can be formed using conventional methods of applying and curing silicone compositions. Also, the methods of the present invention are scaleable to high throughput manufacturing processes.

The coated substrates of the present invention are useful in applications requiring substrates having high resistance to water vapor and oxygen. For examples, the coated substrates can be used as a support for, or as an integral component of numerous electronic devices, including semiconductor devices, liquid crystals, light-emitting diodes, organic light-emitting diodes, optoelectronic devices, optical devices, photovoltaic cells, thin film batteries, and solar cells. Moreover, the coated substrate can be a coated or encapsulated electronic device.

### BRIEF DESCRIPTION OF THE DRAWINGS

Figure 1 shows a cross-sectional view of a first embodiment of a coated substrate according the present invention.

Figure 2 shows a cross-sectional view of the first embodiment of the coated substrate, further comprising an additional inorganic barrier coating on the interfacial coating.

Figure 3 shows a cross-sectional view of the first embodiment of the coated substrate, further comprising at least two alternating inorganic barrier and interfacial coatings on the interfacial coating.

Figure 4 shows a cross-sectional view of a second embodiment of a coated substrate according the present invention.

Figure 5 shows a cross-sectional view of the second embodiment of the coated substrate, further comprising an additional interfacial coating on the inorganic barrier coating.

Figure 6 shows a cross-sectional view of the second embodiment of the coated substrate, further comprising at least two alternating interfacial and inorganic barrier coatings on the inorganic barrier coating.

### DETAILED DESCRIPTION OF THE INVENTION

As used herein, the term "epoxy-substituted organic group" refers to a monovalent organic group in which an oxygen atom, the epoxy substituent, is directly attached to two adjacent carbon atoms of a carbon chain or ring system. Further, the term "mol% of the groups R³ in the silicone resin are radiation-sensitive groups" is defined as the ratio of the number of moles of silicon-bonded radiation-sensitive groups in the silicone resin to the total number of moles of the groups R³ in the resin, multiplied by 100.

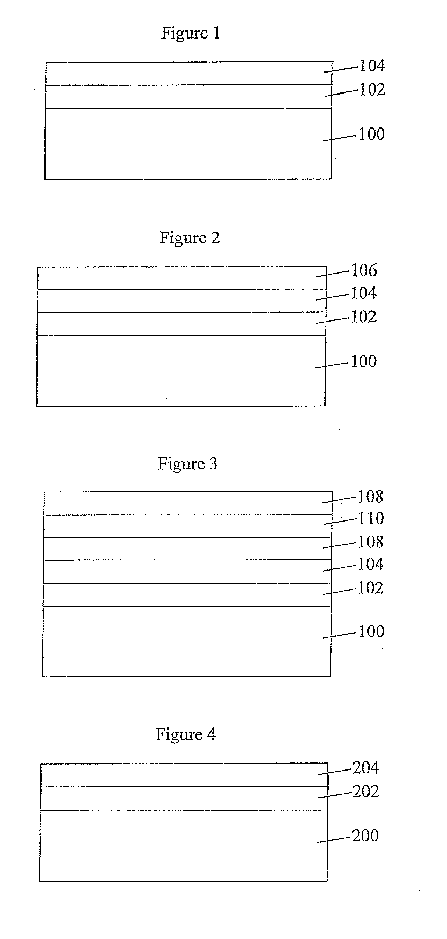

As shown in Figure 1, a first embodiment of a coated substrate according to the present invention comprises a substrate **100,** an inorganic barrier coating **102** on the substrate **100**; and an interfacial coating **104** on the inorganic barrier coating **102**, wherein the interfacial coating **104** comprises a cured product of a silicone resin having the formula (R¹R³₂SiO_{1/2})ₐ(R³₂SiO_{2/2})_{b}(R³SiO_{3/2})_{c}(SiO_{4/2})_{d} (I), wherein each R¹ is independently C₁ to C₁₀ hydrocarbyl, C₁ to C₁₀ halogen-substituted hydrocarbyl, or -OR², wherein R² is C₁ to C₁₀ hydrocarbyl or C₁ to C₁₀ halogen-substituted hydrocarbyl, each R³ is independently R¹ -H, or a radiation-sensitive group, a is from 0 to 0.95, b is from 0 to 0.95, c is from 0 to 1, d is from 0 to 0.9, c+d = 0.1 to 1, and a+b+c+d=1, provided the silicone resin has an average of at least two silicon-bonded radiation-sensitive groups per molecule.

The substrate can be any rigid or flexible material having a planar, complex, or irregular contour. The substrate can be transparent or nontransparent to light in the visible region (∼400 to ∼700 nm) of the electromagnetic spectrum. Also, the substrate can be an electrical conductor, semiconductor, or nonconductor. Moreover, the substrate can be an electronic device, such as a discrete device and an integrated circuit.

Examples of substrates include, but are not limited to, semiconductors such as silicon, silicon having a surface layer of silicon dioxide, silicon carbide, indium phosphide, and gallium arsenide; quartz; fused quartz; aluminum oxide; ceramics; glass; metal foils; polyolefins such as polyethylene, polypropylene, polystyrene, polyethylene terephthalate (PET), and polyethylene naphthalate; fluorocarbon polymers such as polytetrafluoroethylene and polyvinylfluoride; polyamides such as Nylon; polyimides; polyesters such as poly(methyl methacrylate); epoxy resins; polyethers; polycarbonates; polysulfones; and polyether sulfones.

Examples of discrete devices include, but are not limited to, diodes, such as PIN diodes, voltage reference diodes, varactor diodes, Avalanche diodes, DIACs, Gunn diodes, Snap diodes, IMPATT diodes, tunnel diodes, Zener diodes, normal (p-n) diodes, and Shottky diodes; transistors, such as bipolar transistors, including, insulated gate bipolar transistors (IGBTs) and Darlington transistors, and field-effect transistors (FETs), including metal oxide semiconductor FETs (MOSFETs), junction FETs (JFETs), metal-semiconductor FETs (MESFETs), organic FETs, high electron mobility transistors (HEMTs), and thin film transistors (TFTs), including organic field effect transistors; thyristors, for example, DIACs, TRIACs, silicon controlled rectifiers (SCRs), distributed buffer-gate turn-off (DB-GTO) thyristors, gate turn-off (GTO) thyristors, MOFSET controlled thyristors (MCTs), modified anode-gate turn-off (MA-GTO) thyristors, static induction thyristors (SIThs), and field controlled thyristors (FCThs); varistors; resistors; condensers; capacitors; thermistors; and optoelectronic devices, such as photodiodes, solar cells (for example CIGS solar cells and organic photovoltaic cells), phototransistors, photomultipliers, integrated optical circuit (IOC) elements, light-dependent resistors, laser diodes, light-emitting diodes (LEDs), and organic light-emitting diodes (OLEDs), including small-molecule OLEDs (SM-OLEDs) and polymer light-emitting diodes (PLEDs).

Examples of integrated circuits include, but are not limited to, monolithic integrated circuits, such as memory ICs, including RAM (random-access memory), including DRAM and SRAM, and ROM (read-only memory); logic circuits; analog integrated circuits; hybrid integrated circuits, including thin-film hybrid ICs and thick-film hybrid ICs; thin film batteries; and fuel cells.

The inorganic barrier coating can be any barrier coating comprising an inorganic material having a low permeability to water vapor (moisture). The inorganic material can be an electrical conductor, nonconductor, or semiconductor.

The inorganic barrier coating can be a single layer coating comprising one layer of an inorganic material or a multiple layer coating comprising two or more layers of at least two different inorganic materials, where directly adjacent layers comprise different inorganic materials (i.e., inorganic materials have a different composition and/or property). When the layer of inorganic material in a single layer coating comprises two or more elements (e.g. TiN), the layer can be a gradient layer, where the composition of the layer changes with thickness. Similarly, when at least one layer of inorganic material in a multiple layer coating comprises two or more elements, the layer can be a gradient layer. The multiple layer coating typically comprises from 2 to 7 layers, alternatively from 2 to 5 layers, alternatively from 2 to 3 layers.

The single layer inorganic barrier coating typically has a thickness of from 0.03 to 3 µm, alternatively from 0. 1 to 1 µm, alternatively from 0.2 to 0.8 µm. The multiple layer inorganic barrier coating typically has a thickness of from 0.06 to 5 µm, alternatively from 0.1 to 3 µm, alternatively from 0.2 to 2.5 µm. When the thickness of the inorganic barrier coating is less than 0.03 µm, the permeability of the coating to moisture may be too high for some applications. When the thickness of the inorganic barrier coating is greater than 5 µm, the inorganic barrier coating may be susceptible to cracking.

The inorganic barrier coating may be transparent or nontransparent to light in the visible region (∼400 to ∼700 nm) of the electromagnetic spectrum. A transparent inorganic barrier coating typically has a percent transmittance of at least 30%, alternatively at least 60%, alternatively at least 80%, for light in the visible region of the electromagnetic spectrum.

Examples of inorganic materials include, but are not limited to, metals such as aluminum, calcium, magnesium, nickel, and gold; metal alloys such as aluminum magnesium alloy, silver magnesium alloy, lithium aluminum alloy, indium magnesium alloy, and aluminum calcium alloy; oxides such as silicon dioxide, aluminum oxide, titanium(II) oxide, titanium(III) oxide, barium oxide, beryllium oxide, magnesium oxide, tin(II) oxide, tin(IV) oxide, indium(III) oxide, lead(II) oxide, lead(IV) oxide, zinc oxide, tantalum(V) oxide, yttrium(III) oxide, phosphorus pentoxide, boric oxide, zirconium(IV) oxide, and calcium oxide; mixed oxides such as indium tin oxide (ITO), indium zinc oxide (IZO), and indium cerium oxide; nitrides such as silicon nitride, titanium nitride, aluminum nitride, indium(III) nitride, and gallium nitride; mixed nitrides such as aluminum silicon nitride; oxynitrides such as silicon oxynitride, aluminum oxynitride, and boron oxynitride; carbides such as silicon carbide, aluminum carbide, boron carbide, and calcium carbide; oxycarbide such as silicon oxycarbide; mixed oxynitrides such as aluminum silicon oxynitrides and titanium silicon oxynitrides; fluorides such as magnesium fluoride and calcium fluoride; and carbide nitrides such as silicon carbide nitride.

The inorganic barrier coating can be formed as described below in the method of preparing the first embodiment of the coated substrate.

The interfacial coating comprises a cured product of at least one silicone resin having the formula (R¹R³₂SiO_{1/2})ₐ(R³₂SiO_{2/2})_{b}(R³SiO_{3/2})_{c}(SiO_{4/2})_{d} (I), wherein each R¹ is independently C₁ to C₁₀ hydrocarbyl, C₁ to C₁₀ halogen-substituted hydrocarbyl, or - OR², wherein R² is C₁ to C₁₀ hydrocarbyl or C₁ to C₁₀ halogen-substituted hydrocarbyl, each R³ is independently R¹, -H, or a radiation-sensitive group, a is from 0 to 0.95, b is from 0 to 0.95, c is from 0 to 1, d is from 0 to 0.9, c+d = 0.1 to 1, and a+b+c+d=1, provided the silicone resin has an average of at least two silicon-bonded radiation-sensitive groups per molecule.

As used herein, the term "cured product of a silicone resin" refers to a cross-linked silicone resin having a three-dimensional network structure. The interfacial coating can be a single layer coating comprising one layer of a cured product of a silicone resin having the formula (I), or a multiple layer coating comprising two or more layers of at least two different cured products of silicone resins having the formula (I), where directly adjacent layers comprise different cured products (i.e., cured products have a different composition and/or property). The multiple layer coating typically comprises from 2 to 7 layers, alternatively from 2 to 5 layers, alternatively from 2 to 3 layers.

The single layer interfacial coating typically has a thickness of from 0.03 to 30 µm, alternatively from 0.1 to 10 µm, alternatively from 0. 1 to 1.5 µm. The multiple layer interfacial coating typically has a thickness of from 0.06 to 30 µm, alternatively from 0.2 to 10 µm, alternatively 0.2 to 3 µm. When the thickness of the interfacial coating is less than 0.03 µm, the coating may become discontinuous. When the thickness of the interfacial coating is greater than 30 µm, the coating may exhibit reduced adhesion and/or cracking.

The interfacial coating typically exhibits high transparency. For example, the interfacial coating typically has a percent transmittance of at least 90%, alternatively at least 92%, alternatively at least 94%, for light in the visible region (∼400 to ∼700 nm) of the electromagnetic spectrum.

The silicone resin having the formula (I) can contain T siloxane units, T and Q siloxane units, or T and/or Q siloxane units in combination with M and/or D siloxane units. For example, the silicone resin can be a T resin, a TQ resin, an MT resin, a DT resin, an MDT resin, an MQ resin, a DQ resin, an MDQ resin, an MTQ resin, a DTQ resin, or an MDTQ resin. Moreover, the silicone resin having the formula (I), wherein c=1, can be a homopolymer or a copolymer.

The hydrocarbyl and halogen-substituted hydrocarbyl groups represented by R¹ and R² typically have from 1 to 10 carbon atoms, alternatively from 1 to 6 carbon atoms, alternatively from 1 to 4 carbon atoms. Acyclic hydrocarbyl and halogen-substituted hydrocarbyl groups containing at least 3 carbon atoms can have a branched or unbranched structure. Examples of hydrocarbyl groups include, but are not limited to, alkyl, such as methyl, ethyl, propyl, 1-methylethyl, butyl, 1-methylpropyl, 2-methylpropyl, 1,1-dimethylethyl, pentyl, 1-methylbutyl, 1-ethylpropyl, 2-methylbutyl, 3-methylbutyl, 1,2-dimethylpropyl, 2,2-dimethylpropyl, hexyl, heptyl, octyl, nonyl, and decyl; cycloalkyl, such as cyclopentyl, cyclohexyl, and methylcyclohexyl; aryl, such as phenyl and naphthyl; alkaryl, such as tolyl and xylyl; aralkyl, such as benzyl and phenethyl; alkenyl, such as vinyl, allyl, and propenyl; arylalkenyl, such as styryl and cinnamyl; and alkynyl, such as ethynyl and propynyl. Examples of halogen-substituted hydrocarbyl groups include, but are not limited to, 3,3,3-trifluoropropyl, 3-chloropropyl, chlorophenyl, dichlorophenyl, 2,2,2-trifluoroethyl, 2,2,3,3-tetrafluoropropyl, and 2,2,3,3,4,4,5,5-octafluoropentyl.

Examples of radiation-sensitive groups represented by R³ include, but are not limited to, acryloyloxyalkyl, substituted acryloyloxyalkyl, an alkenyl ether group, alkenyl, and an epoxy-substituted organic group. As used herein, the term "radiation-sensitive group" means the group forms a reactive species, for example a free radical or cation, in the presence of a free radical or cationic photoinitiator when exposed to radiation having a wavelength of from 150 to 800 nm.

Examples of acryloyloxyalkyl groups represented by R³ include, but are not limited to, acryloyloxymethyl, 2-acryloyloxyethyl, 3-acryloyloxyypropyl, and 4-acryloyloxybutyl.

Examples of substituted acryloyloxyalkyl groups represented by R³ include, but are not limited to, methacryloyloxymethyl, 2-methacryloyloxyethyl, and 3-methacryloyloxylpropyl.

Examples of alkenyl ether groups represented by R³ include, but are not limited to, a vinyl ether group having the formula and -O-R⁴-O-CH=CH₂, wherein R⁴ is C₁ to C₁₀ hydrocarbylene or C₁ to C₁₀ halogen-substituted hydrocarbylene.

The hydrocarbylene groups represented by R⁴ typically have from 1 to 10 carbon atoms, alternatively from 1 to 6 carbon atoms, alternatively from 1 to 4 carbon atoms. Examples of hydrocarbylene groups include, but are not limited to, alkylene such as methylene, ethylene, propane-1,3-diyl, 2-methylpropane-1,3-diyl, butane-1,4-diyl, butane-1,3-diyl, pentane-1,5,-diyl, pentane-1,4-diyl, hexane-1,6-diyl, octane-1,8-diyl, and decane-1,10-diyl; cycloalkylene such as cyclohexane-1,4-diyl; arylene such as phenylene. Examples of halogen-substituted hydrocarbylene groups include, but are not limited to, divalent hydrocarbon groups wherein one or more hydrogen atoms have been replaced by halogen, such as fluorine, chlorine, and bromine, such as -CH₂CH₂CF₂CF₂CH₂CH₂-.

Examples of alkenyl groups represented by R³ include, but are not limited to, vinyl, allyl, propenyl, butenyl, and hexenyl.

Examples of epoxy-substituted organic groups represented by R³ include, but are not limited to, 2,3-epoxypropyl, 3,4-epoxybutyl, 4,5-epoxypentyl, 2-glycidoxyethyl, 3-glycidoxypropyl, 4-glycidoxybutyl, 2-(3,4-epoxycylohexyl)ethyl, 3-(3,4-epoxycylohexyl)propyl, 2-(3,4-epoxy-3-methylcylohexyl)-2-methylethyl, 2-(2,3-epoxycylopentyl)ethyl, and 3-(2,3 epoxycylopentyl)propyl.

In the formula (I) of the silicone resin, the subscripts a, b, c, and d are mole fractions. The subscript a typically has a value of from 0 to 0.95, alternatively from 0 to 0.8, alternatively from 0 to 0.2; the subscript b typically has a value of from 0 to 0.95, alternatively from 0 to 0.8, alternatively from 0 to 0.5; the subscript c typically has a value of from 0 to 1, alternatively from 0.3 to 1, alternatively from 0.5 to 1; the subscript d typically has a value of from 0 to 0.9, alternatively from 0 to 0.5, alternatively from 0 to 0.1; and the sum c+d typically has value of from 0.1 to 1, alternatively from 0.2 to 1, alternatively from 0.5 to 1, alternatively 0.8 to 1.

The silicone resin typically has a weight-average molecular weight (M_{w}) of from 500 to 1,000,000, alternatively from 1,000 to 100,000, alternatively from 1,000 to 50,000, alternatively from 1,000 to 20,000, alternatively form 1,000 to 10,000, where the molecular weight is determined by gel permeation chromatography employing a refractive index detector and polystyrene standards.

The silicone resin typically contains an average of at least two silicon-bonded radiation-sensitive groups per molecule. Generally, at least 50 mol%, alternatively at least 65 mol%, alternatively at least 80 mol% of the groups R³ in the silicone resin are radiation-sensitive groups.

Examples of silicone resins include, but are not limited to, resins having the following formulae:
(MeSiO_{3/2})_{0.25}(CH₂=C(CH₃)COO(CH₂)₃SiO_{3/2})_{0.75},
(MeSiO_{3/2})_{0.5}(CH₂=C(CH₃)COO(CH₂)₃SiO_{3/2})_{0.5},
(MeSiO_{3/2})_{0.67}(CH₂=C(CH₃)COO(CH₂)₃SiO_{3/2})_{0.33},
(PhSiO_{3/2})_{0.25}(CH₂=C(CH₃)COO(CH₂)₃SiO_{3/2})_{0.75},
(PhSiO_{3/2})_{0.5}(CH₂₌C(CH₃)COO(CH₂)₃SiO_{3/2})_{0.5},
(PhSiO_{3/2})_{0.67}(CH₂=C(CH₃)COO(CH₂)₃SiO_{3/2})_{0.33},
(MeSiO_{3/2})_{0.25}(CH₂=C(CH₃)COO(CH₂)₃SiO_{3/2})_{0.72}(Me₃SiO_{1/2})_{0.03},
(MeSiO_{3/2})_{0.5}(CH₂=C(CH₃)COO(CH₂)₃SiO_{3/2})_{0.47}(Me₃SiO_{1/2})_{0.03},
(MeSiO_{3/2})_{0.67}(CH₂=C(CH₃)COO(CH₂)₃SiO_{3/2})_{0.30}(Me₃SiO_{1/2})_{0.03},
(MeSiO_{3/2})_{0.67}(CH₂=CHCOO(CH₂)₃SiO_{3/2})_{0.33},
(PhSiO_{3/2})_{0.67}(CH₂=CHCOO(CH₂)₃SiO_{3/2})_{0.33}, 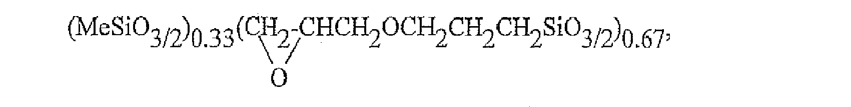 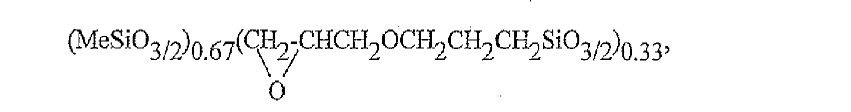 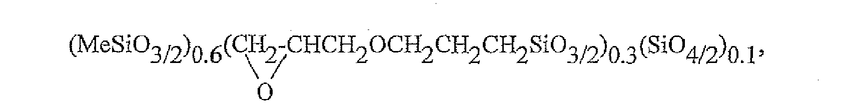 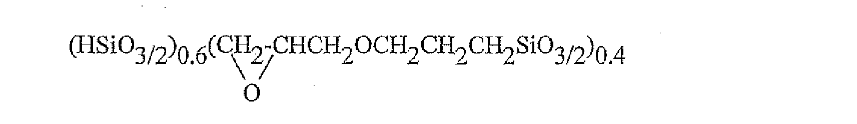 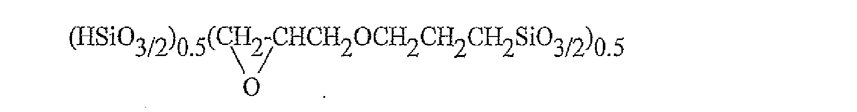 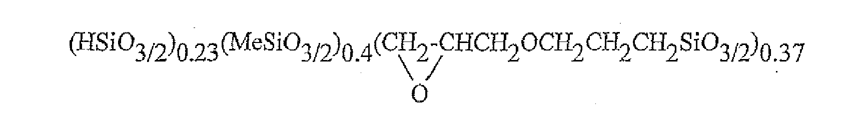 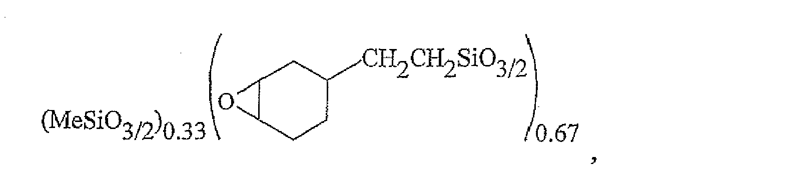 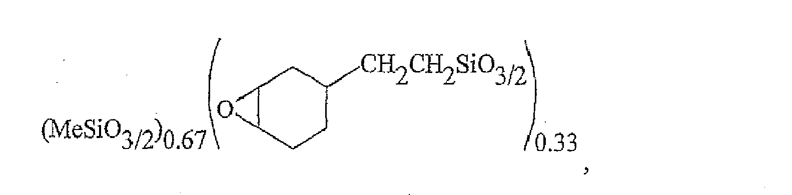 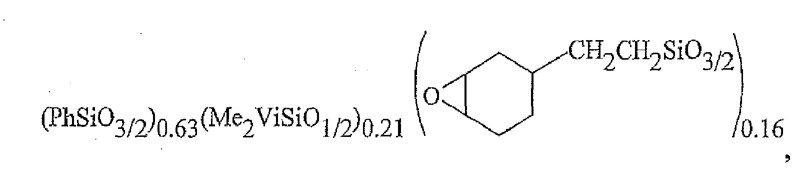 and
(MeSiO_{3/2})_{0.485}(HSiO_{3/2})_{0.485}(ViSiO_{3/2})_{0.3},
where Me is methyl, Ph is phenyl, Vi is vinyl, and the numerical subscripts outside the parenthesis denote mole fractions. Also, in the preceding formula, the sequence of units is unspecified.

Methods of preparing silicone resins having silicon-bonded radiation-sensitive groups are known in the art. For example, silicone resins containing silicon-bonded acryloyloxyalkyl or substituted acryloyloxyalkyl groups can be prepared by co-hydrolyzing an acryloyloxyalkyl- or substituted-acryloyloxyalkylalkoxysilane and an alkoxysilane in the presence of an acidic or basic catalyst, as exemplified in U.S. Patent No. 5,738,976 and U.S. Patent No. 5,959,038. Alternatively, such resins can be produced by co-hydrolyzing an acryloyloxyalkyl- or substituted-acryloyloxayalkylchlorosilane and at least one chlorosilane, as taught in U.S. Patent No. 4,568,566.

Silicone reins containing silicon-bonded alkenyl ether groups can be prepared by reacting an alkoxysilane with water in the presence of an acidic condensation catalyst and subsequently treating the reaction mixture with a hydroxy-substituted vinyl ether and a transesterification catalyst, as described in U.S. Patent No. 5,861,467. In brief this method comprises the steps of (I) reacting (a) a silane having the formula RₓSi(OR¹)₄₋ₓ, (b) water, and (c) an acidic condensation catalyst; (II) removing alcohol from the mixture of step (I), (III) neutralizing the mixture of step (II), (IV) adding a vinyl ether compound having the formula HO-R²-O-CH=CH₂, (V) adding a transesterification catalyst to the mixture of step (IV); and (VI) removing volatiles from the mixture of step (V); wherein R is a monovalent hydrocarbon or halohydrocarbon radical having from 1 to 20 carbon atoms, R¹ is a monovalent alkyl radical having from 1 to 8 carbon atoms, R² is a divalent hydrocarbon or halohydrocarbon radical having from 1 to 20 carbon atoms, and x has a value of from 0 to 3, with the proviso that the molar ratio of water to alkoxy radicals is less than 0.5.

Alternatively, silicone resins containing alkenyl ether groups can be prepared by reacting an alkoxysilane, water, and a hydroxy-substituted vinyl ether compound in the presence of a non-acidic condensation catalyst, and then treating the reaction mixture with a transesterification catalyst, as described in U.S. Patent No. 5,824,761. Briefly, this method comprises (I) reacting (a) a silane having the formula RₓSi(OR¹)₄₋ₓ, (b) water, (c) a non-acidic condensation catalyst selected from amine carboxylates, heavy metal carboxylates, isocyanates, silanolates, phenoxides, mercaptides, CaO, BaO, LiOH, BuLi, amines, and ammonium hydroxides, and (d) a vinyl ether compound having the formula HO-R²-O-CH=CH₂; (II) removing alcohol from the mixture of (I); (III) neutralizing the mixture of (II); (IV) adding a transesterification catalyst to the mixture of (III); and (V) removing volatiles from the mixture of (IV); wherein R is a monovalent hydrocarbon or halohydrocarbon radical having from 1 to 20 carbon atoms, R¹ is a monovalent alkyl radical having from 1 to 8 carbon atoms, R² is a divalent hydrocarbon or halohydrocarbon radical having from 1 to 20 carbon atoms, and x has a value of from 0 to 3, with the proviso that the molar ratio of water to alkoxy radicals is less than 0.5.

Silicone resins containing silicon-bonded alkenyl groups can be prepared by cohydrolyzing the appropriate mixture of chlorosilane precursors in an organic solvent, such as toluene. For example, a silicone resin comprising (CH₃)₃SiO_{1/2} units, CH₃SiO_{3/2} units, and H₂C=CHSiO_{3/2} units can be prepared by cohydrolyzing a compound having the formula (CH₃)₃SiCl, a compound having the formula CH₃SiCl₃, and a compound having the formula H₂C=CHSiCl₃ in toluene. The aqueous hydrochloric acid and silicone hydrolyzate are separated and the hydrolyzate is washed with water to remove residual acid and heated in the presence of a mild condensation catalyst to "body" the resin to the requisite viscosity. If desired, the resin can be further treated with a condensation catalyst in an organic solvent to reduce the content of silicon-bonded hydroxy groups. Alternatively, silanes containing hydrolysable groups other than chloro, such-Br, -I, -OCH₃, -OC(O)CH₃, -N(CH₃)₂, NHCOCH₃, and -SCH₃, can be utilized as starting materials in the cohydrolysis reaction. The properties of the resin products depend on the types of silanes, the mole ratio of silanes, the degree of condensation, and the processing conditions.

Silicone resins containing silicon-bonded epoxy-substituted organic groups can be prepared by cohydrolyzing an epoxy-functional alkoxysilane and an alkoxysilane in the presence of an organotitanate catalyst, as described in U.S. Patent No. 5,468,826. Alternatively, silicone resins containing silicon-bonded epoxy-substituted organic groups can be prepared by reacting a silicone resin containing silicon-bonded hydrogen atoms with an epoxy-functional alkene in the presence of a hydrosilylation catalyst, as described in U.S. Patent Nos. 6,831,145; 5,310,843; 5,530,075; 5,283,309; 5,468,827; 5,486,588; and 5,358,983. In particular, methods of preparing silicone resins containing silicon-bonded epoxy-substituted organic groups and silicon-bonded hydrogen atoms are described in the Examples section below.

The interfacial coating can be formed as described below in the method of preparing the first embodiment of the coated substrate.

As shown in Figure 2, the first embodiment of the coated substrate can further comprise an additional inorganic barrier coating **106** on the interfacial coating **104**. The additional inorganic barrier coating **106** is as described and exemplified above for the inorganic barrier coating **102** of the first embodiment of the coated substrate.

As shown in Figure 3, the first embodiment of the coated substrate can further comprise at least two (three shown) alternating inorganic barrier **108** and interfacial **110** coatings on the interfacial coating **104**, wherein each alternating interfacial coating **110** comprises a cured product of a silicone resin having the formula (I). The alternating inorganic barrier **108** and alternating interfacial **110** coatings are as described above for the inorganic barrier **102** and interfacial **104** coatings of the first embodiment of the coated substrate.

The first embodiment of the coated substrate can be prepared by forming an inorganic barrier coating on a substrate; and forming an interfacial coating on the inorganic barrier coating, wherein the interfacial coating comprises a cured product of a silicone resin having the formula (I).

In the first step of the preceding method of preparing a coated substrate, an inorganic barrier coating is formed on a substrate. The substrate and inorganic barrier coating are as described and exemplified above for the first embodiment of the coated substrate.

Methods of forming inorganic barrier coatings are well known in the art. For example inorganic barrier coatings can be deposited using chemical vapor deposition techniques, such as thermal chemical vapor deposition, plasma enhanced chemical vapor deposition, photochemical vapor deposition, electron cyclotron resonance, inductively coupled plasma, magnetically confined plasma, and jet vapor deposition; and physical vapor deposition techniques, such as RF sputtering, atomic layer deposition, and DC magnetron sputtering.

In the second step of the method of preparing the first embodiment of the coated substrate, an interfacial coating is formed on the inorganic barrier coating, wherein the interfacial coating comprises a cured product of a silicone resin having the formula (I). The interfacial coating is as described and exemplified above for the first embodiment of the coated substrate.

The interfacial coating can be formed using a variety of methods. For example, the interfacial coating can be formed by (i) applying a silicone composition comprising a silicone resin having the formula (I) on the inorganic barrier coating and (ii) curing the silicone resin.

The silicone composition can be any silicone composition comprising a silicone resin having the formula (I), described and exemplified above. The silicone composition can comprise a single silicone resin or two or more different silicone resins, each having the formula (I).

The silicone composition can comprise additional ingredients, provided the ingredient does not prevent the silicone resin from curing to form the interfacial layer, described above, of the coated substrate. Examples of additional ingredients include, but are not limited to, adhesion promoters; dyes; pigments; anti-oxidants; heat stabilizers; flame retardants; flow control additives; fillers, including extending and reinforcing fillers; organic solvents; cross-linking agents; photoinitiators; and organic peroxides.

For example, the silicone composition can further comprise at least one photoinitiator. The photoinitiator can be a cationic or free radical photoinitiator, depending on the nature of the radiation-sensitive groups in the silicone resin. For example, when the resin contains alkenyl ether or epoxy-substituted organic groups, the silicone composition can further comprise at least one cationic photoinitiator. The cationic photoinitiator can be any cationic photoinitiator capable of initiating cure (cross-linking) of the silicone resin upon exposure to radiation having a wavelength of from 150 to 800 nm. Examples of cationic photoinitiators include, but are not limited to, onium salts, diaryliodonium salts of sulfonic acids, triarylsulfonium salts of sulfonic acids, diaryliodonium salts of boronic acids, and triarylsulfonium salts of boronic acids.

Suitable onium salts include salts having a formula selected from R⁷₂ I⁺ MX_{z}⁻, R⁷₃ S⁺ MX_{z}⁻, R⁷₃ Se⁺ MX_{z}⁻, R⁷₄ P⁺ MX_{z}⁻, and R⁷₄ N⁺ MX_{z}⁻, wherein each R⁷ is independently hydrocarbyl or substituted hydrocarbyl having from 1 to 30 carbon atoms; M is an element selected from transition metals, rare earth metals, lanthanide metals, metalloids, phosphorus, and sulfur; X is a halo (e.g., chloro, bromo, iodo), and z has a value such that the product z (charge on X + oxidation number of M) = -1. Examples of substituents on the hydrocarbyl group include, but are not limited to, C₁ to Cg alkoxy, C₁ to C₁₆ alkyl, nitro, chloro, bromo, cyano, carboxyl, mercapto, and heterocyclic aromatic groups, such as pyridyl, thiophenyl, and pyranyl. Examples of metals represented by M include, but are not limited to, transition metals, such as Fe, Ti, Zr, Sc, V, Cr, and Mn; lanthanide metals, such as Pr, and Nd; other metals, such as Cs, Sb, Sn, Bi, Al, Ga, and In; metalloids, such as B, and As; and P. The formula MX_{z}⁻ represents a non-basic, non-nucleophilic anion. Examples of anions having the formula MX_{z}⁻ include, but are not limited to, BF₄⁻, PF₆⁻, AsF₆⁻, SbF₆⁼, SbCl₆⁻, and SnCl₆⁻.

Examples of onium salts include, but are not limited to, bis-diaryliodonium salts, such as bis(dodecyl phenyl)iodonium hexafluoroarsenate, bis(dodecylphenyl)iodonium hexafluoroantimonate, and dialkylphenyliodonium hexafluoroantimonate.

Examples of diaryliodonium salts of sulfonic acids include, but are not limited to, diaryliodonium salts of perfluoroalkylsulfonic acids, such as diaryliodonium salts of perfluorobutanesulfonic acid, diaryliodonium salts of perfluoroethanesulfonic acid, diaryliodonium salts of perfluorooctanesulfonic acid, and diaryliodonium salts of trifluoromethanesulfonic acid; and diaryliodonium salts of aryl sulfonic acids, such as diaryliodonium salts of para-toluenesulfonic acid, diaryliodonium salts of dodecylbenzenesulfonic acid, diaryliodonium salts of benzenesulfonic acid, and diaryliodonium salts of 3-nitrobenzenesulfonic acid.

Examples of triarylsulfonium salts of sulfonic acids include, but are not limited to, triarylsulfonium salts of perfluoroalkylsulfonic acids, such as triarylsulfonium salts of perfluorobutanesulfonic acid, triarylsulfonium salts of perfluoroethanesulfonic acid, triarylsulfonium salts of perfluorooctanesulfonic acid, and triarylsulfonium salts of trifluoromethanesulfonic acid; and triarylsulfonium salts of aryl sulfonic acids, such as triarylsulfonium salts of para-toluenesulfonic acid, triarylsulfonium salts of dodecylbenzenesulfonic acid, triarylsulfonium salts of benzenesulfonic acid, and triarylsulfonium salts of 3-nitrobenzenesulfonic acid.

Examples of diaryliodonium salts of boronic acids include, but are not limited to, diaryliodonium salts of perhaloarylboronic acids. Examples of triarylsulfonium salts of boronic acids include, but are not limited to, triarylsulfonium salts of perhaloarylboronic acid. Diaryliodonium salts of boronic acids and triarylsulfonium salts of boronic acids are well known in the art, as exemplified in European Patent Application No. EP 0562922.

The cationic photoinitiator can be a single cationic photoinitiator or a mixture comprising two or more different cationic photoinitiators, each as described above. The concentration of the cationic photoinitiator is typically from 0.01 to 20% (w/w), alternatively from 0.1 to 20% (w/w), alternatively from 0.1 to 5%, based on the weight of the silicone resin.

When the silicone resin contains acryoyloxyalkyl, substituted acryloyloxyalkyl, or alkenyl groups, the silicone composition can further comprise at least one free radical photoinitiator. The free radical photoinitiator can be any free radical photoinitiator capable of initiating cure (cross-linking) of the silicone resin upon exposure to radiation having a wavelength of from 150 to 800 nm.

Examples of free radical photoinitiators include, but are not limited to, benzophenone; 4,4'-bis(dimethylamino)benzophenone; halogenated benzophenones; acetophenone; α-hydroxyacetophenone; chloro acetophenones, such as dichloroacetophenones and trichloroacetophenones; dialkoxyacetophenones, such as 2,2-diethoxyacetophenone; α-hydoxyalkylphenones, such as 2-hydroxy-2-methyl-1-phenyl-1-propanone and 1-hydroxycyclohexyl phenyl ketone; α-aminoalkylphenones, such as 2-methyl-4'-(methylthio)-2-morpholiniopropiophenone; benzoin; benzoin ethers, such as benzoin methyl ether, benzoin ethyl ether, and benzoin isobutyl ether; benzil ketals, such as 2,2-dimethoxy-2-phenylacetophenone; acylphosphinoxides, such as diphenyl(2,4,6-trimethylbenzoyl)phosphine oxide; xanthone derivatives; thioxanthone derivatives; fluorenone derivatives; methyl phenyl glyoxylate; acetonaphthone; anthraquninone derivatives; sufonyl chlorides of aromatic compounds; and *O*-acyl α-oximinoketones, such as 1-phenyl-1,2-propanedione-2-(*O*-ethoxycarbonyl)oxime.

The free radical photoinitiator can also be a polysilane, such as the phenylmethylpolysilanes defined by West in U.S. Pat. No. 4,260,780, which is hereby incorporated by reference; the aminated methylpolysilanes defined by Baney et al. in U.S. Pat. No. 4,314,956, which is hereby incorporated by reference; the methylpolysilanes of Peterson et al. in U.S. Pat. No. 4,276,424, which is hereby incorporated by reference; and the polysilastyrene defined by West et al. in U.S. Pat. No. 4,324,901, which is hereby incorporated by reference.

The free radical photoinitiator can be a single free radical photoinitiator or a mixture comprising two or more different free radical photoinitiators. The concentration of the free radical photoinitiator is typically from 0.1 to 20% (w/w), alternatively from 1 to 10% (w/w), based on the weight of the silicone resin.

When the silicone composition comprises a silicone resin having silicon-bonded alkenyl groups, acryloyloxyalkyl groups, or substituted acryloyloxyalkyl, the silicone composition can further comprise at least one organic peroxide. Examples of organic peroxides include, diaroyl peroxides such as dibenzoyl peroxide, di-p-chlorobenzoyl peroxide, and bis-2,4-dichlorobenzoyl peroxide; dialkyl peroxides such as di-t-butyl peroxide and 2,5-dimethyl-2,5-di-(t-butylperoxy)hexane; diaralkyl peroxides such as dicumyl peroxide; alkyl aralkyl peroxides such as t-butyl cumyl peroxide and 1,4-bis(t-butylperoxyisopropyl)benzene; and alkyl aroyl peroxides such as t-butyl perbenzoate, t-butyl peracetate, and t-butyl peroctoate.

The organic peroxide can be a single peroxide or a mixture comprising two or more different peroxides. The concentration of the organic peroxide is typically from 0.1 to 20% (w/w), alternatively from 1 to 10% (w/w), based on the weight of the silicone resin.

When the silicone composition contains two or more components, the composition is typically prepared by combining the silicone resin and any optional ingredients in the stated proportions at ambient temperature. Mixing can be accomplished by any of the techniques known in the art such as milling, blending, and stirring, either in a batch or continuous process. The particular device is determined by the viscosity of the components and the viscosity of the final silicone composition.

The silicone composition can be applied on the inorganic barrier coating using conventional methods such as spin-coating, dipping, spraying, and brushing.

The silicone resin can be cured using a variety of methods, depending on whether the silicone composition contains a photoinitiator or an organic peroxide. For example, the silicone resin can be cured by heating the resin at a temperature of from room temperature (∼23 ± 2 °C) to 250 °C, alternatively from room temperature to 200 °C, alternatively from room temperature to 1.80 °C, at atmospheric pressure.

Alternatively, the silicone resin can be cured by exposing the resin to an electron beam. Typically, the accelerating voltage is from about 0.1 to 100 keV, the vacuum is from about 14 to 10-3 Pa, the electron current is from about 0.0001 to 1 ampere, and the power varies from about 0.1 watt to 1 kilowatt. The dose is typically from about 100 microcoulomb/cm² to 100 coulomb/cm², alternatively from about 1 to 10 coulombs/cm². Depending on the voltage, the time of exposure is typically from about 10 seconds to 1 hour.

Also, when the silicone composition further comprises a cationic or free radical photoinitiator, described above, the silicone resin can be cured by exposing the resin to radiation having a wavelength of from 150 to 800 nm, alternatively from 200 to 400 nm, at a dosage sufficient to cure (cross-link) the silicone resin. The light source is typically a medium pressure mercury-arc lamp. The dose of radiation is typically from 30 to 1,000 mJ/cm², alternatively from 50 to 500 mJ/cm². Moreover, the film can be externally heated during or after exposure to radiation to enhance the rate and/or extent of cure.

Further, when the silicone composition further comprises an organic peroxide, the silicone resin can be cured by exposing the resin to an electron beam, as described above, or by heating the film at a temperature of from room temperature (∼23 ± 2 °C) to 180 °C, for a period of from 0.05 to 1 h.

The method of preparing the first embodiment of the coated substrate can further comprise forming an additional inorganic barrier coating on the interfacial coating. Alternatively, the method can further comprise forming at least two alternating inorganic barrier and interfacial coatings on the interfacial coating, wherein each alternating interfacial coating comprises a cured product of a silicone resin having the formula (I).

Also, the surface of the substrate, inorganic barrier coating, and/or interfacial coating described above can be physically or chemically treated prior to forming an inorganic barrier or interfacial coating thereon. Examples of surface treatments include, but are not limited to, solvent wash, corona discharge, plasma discharge, application of a primer, and physical roughening.

As shown in Figure 4, a second embodiment of a coated substrate according to the present invention comprises a substrate **200;** an interfacial coating **202** on the substrate **200,** wherein the interfacial coating **202** comprises a cured product of a silicone resin having the formula (I); and an inorganic barrier coating **204** on the interfacial coating **202.** The substrate, interfacial coating, and inorganic barrier coating are as described and exemplified above for the first embodiment of the coated substrate.

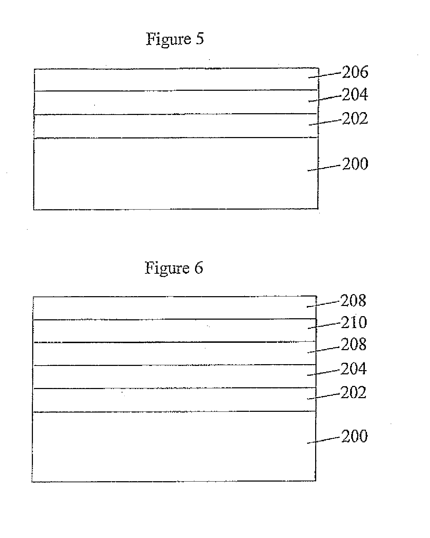

As shown in Figure 5, the second embodiment of the coated substrate can further comprise an additional interfacial coating **206** on the inorganic barrier coating **204,** wherein the additional interfacial coating **206** comprises a cured product of a silicone resin having the formula (I). The additional interfacial coating is as described and exemplified above for the interfacial coating of the first embodiment of the coated substrate.

As shown in Figure 6, the second embodiment of the coated substrate can further comprise at least two (three shown) alternating interfacial **208** and inorganic barrier **210** coatings on the inorganic barrier coating **204,** wherein each alternating interfacial coating **208** comprises a cured product of a silicone resin having the formula (I). The alternating interfacial and inorganic barrier coatings are as described and exemplified above for the interfacial and inorganic barrier coatings of the first embodiment of the coated substrate.

The second embodiment of the coated substrate can be prepared by forming an interfacial coating on a substrate, wherein the interfacial coating comprises a cured product of a silicone resin having the formula (I); and forming an inorganic barrier coating on the interfacial coating. The interfacial coating can be formed by (i) applying a silicone composition comprising a silicone resin having the formula (I) on the substrate and (ii) curing the silicone resin. The silicone composition, method of applying the composition, and method of curing the silicone resin are as described above for the method of preparing the first embodiment of the coated substrate. Also, the inorganic barrier coating can be formed on the interfacial coating using the methods described above for preparing the first embodiment of the coated substrate.

The method of preparing the second embodiment of the coated substrate can further comprise forming an additional interfacial coating on the inorganic barrier coating, wherein the additional interfacial coating comprises a cured product of a silicone resin having the formula (I). Alternatively, the method can further comprise forming at least two alternating interfacial and inorganic barrier coatings on the inorganic barrier coating, wherein each alternating interfacial coating comprises a cured product of a silicone resin having the formula (I).

The composite inorganic barrier and interfacial coatings of the coated substrate have a low water vapor transmission rate, typically from 1 x 10⁻⁷ to 3 g/m²/day. Also, the coatings have low permeability to oxygen and metal ions, such as copper and aluminum. Further, the coatings can be transparent or nontransparent to light in the visible region of the electromagnetic spectrum. Still further, the coatings have high resistance to cracking and low compressive stress.

The methods of the present invention can be carried out using conventional equipment and techniques, and readily available silicone compositions. For example inorganic barrier coatings can be deposited using chemical vapor deposition techniques and physical vapor deposition techniques. Moreover, interfacial coatings can be formed using conventional methods of applying and curing silicone compositions. Also, the methods of the present invention are scaleable to high throughput manufacturing processes.

The coated substrates of the present invention are useful in applications requiring substrates having high resistance to water vapor and oxygen. For examples, the coated substrates can be used as a support for, or as an integral component of numerous electronic devices, including semiconductor devices, liquid crystals, light-emitting diodes, organic light-emitting diodes, optoelectronic devices, optical devices, photovoltaic cells, thin film batteries, and solar cells. Moreover, the coated substrate can be a coated or encapsulated electronic device.

### EXAMPLES

The following examples are presented to better illustrate the coated substrates and methods of the present invention, but are not to be considered as limiting the invention, which is delineated in the appended claims. Unless otherwise noted, all parts and percentages reported in the examples are by weight. The following methods and materials were employed in the examples:

### NMR Spectra

Nuclear magnetic resonance spectra (²⁹Si NMR and ¹³C NMR) of silicone resins were obtained using a Varian Mercury 400 MHz NMR spectrometer. The resin (0.5-1.0g) was dissolved in 2.5-3mL of chloroform-d in a 0.5 oz glass vial. The solution was transferred to a Teflon NMR tube and 3-4 mL of a solution of Cr(acac)₃ in chloroform-d (0.04 M) was added to the tube.

### Molecular Weight

Weight-average molecular weight (M_{W}) of silicone resins having radiation-sensitive groups were determined by gel permeation chromatography (GPC) using a PLgel (Polymer Laboratories, Inc.) 5-µm column at 35 °C, a THF mobile phase at 1 mL/min, and a refractive index detector. Polystyrene standards were used for a calibration curve (3^{rd} order). The M_{W} of hydrogensilsesquioxane resins were determined in the same manner, only the mobile phase was toluene.

### Thickness and Refractive Index

The thickness and refractive index of barrier and interfacial coatings on silicon wafers were determined using a J.A. Woollam XLS-100 VASE Ellipsometer. The reported values for thickness, expressed in units of nm, represent the average of nine measurements performed on different regions of the same coated wafer. Refractive index was determined at 23 °C for light having a wavelength of 589 nm.

### Compressive Stress

Compressive stress of coatings on silicon wafers was determined using a KLA Tencor FLX-2320 (KLA Tencor, Milpitas, CA) Thin Film Stress Measurement System at a temperature of 18-22 °C.

### Transmittance

The UV-Visible spectra (200-800 nm) of coated glass wafers were characterized using a Shimadzu Scientific Instruments Model UV-2401PC Spectrophotometer. Background scans were performed with an empty sample chamber in air. Percent transmittance was calculated from absorbance values at 430 nm, 470 nm, 530 um, 550 nm, and 650 nm.

### Density

Density of barrier layers comprising hydrogenated silicon oxycarbide was determined by measuring the mass, thickness, and surface area of a film deposited on a circular substrate having a diameter of 10.2 cm. The mass of a layer was determined using an analytical balance having an accuracy of 1 x 10⁻⁵ g under ambient conditions (25 °C, 101.3 kPa).]

### Deposition of Inorganic Barrier Coatings

The deposition chamber was thoroughly cleaned before the preparation of each coated substrate by first plasma etching the interior surfaces of the chamber for 5 to 10 min. using a plasma generated from CF₄ and O₂ at a pressure of 40 Pa, a CF₄ flow rate of 500 sccm, an O₂ flow rate of 100 seem, an LF power of 40 W, and an RF power of 500 W. After plasma etching, the walls of the chamber were wiped with isopropyl alcohol, and dried with nitrogen.

The inorganic barrier coatings (silicon carbide, hydrogenated silicon oxycarbide) were deposited using a Model No. 2212 HDP parallel plate chemical vapor deposition system from Applied Process Technologies (Tucson, Az) operating in a dual frequency mode at a substrate temperature of 25 °C, a pressure of 0.09 Torr (12.0 Pa), an RF power source connected to the top electrode (shower head) and an LF power source connected to the bottom electrode (substrate holder).

### Deposition of Calcium

Calcium was deposited on glass wafers to a thickness of 100 nm by thermal evaporation (upward technique) through a shadow mask having a 3 x 3 array of 1-in. square apertures using a BOC Edwards model E306A Coating System under an initial pressure of 10⁻⁶ mbar. The coating system was equipped with a crystal balance film thickness monitor. The source was prepared by placing the metal in an aluminum oxide crucible and positioning the crucible in a tungsten wire spiral, or by placing the metal directly in a tungsten basket. The deposition rate (0.1 to 0.3 nm per second) and the thickness of the films were monitored during the deposition process. A 3 x 3 array of 1-in. square highly reflective metallic mirrors were produced on each glass wafer.

### Deposition of Titanium Nitride

Titanium nitride (TiN) was deposited on a layer of hydrogenated silicon oxycarbide (SiCOH) to a thickness of 100 nm using a Denton DV-502A sputtering system. At a base pressure of 1x10⁻⁶ Torr (0.13 mPa), argon was introduced into the chamber until the pressure reached 3 mTorr (0.4 Pa). After depositing TiN for 1 min. at a power of 50 Watts on the back of the target shield, a 95:5 (v/v) mixture of nitrogen and argon was introduced into the chamber while maintaining a pressure of 3 mTorr (0.4 Pa). The target shield was opened, the power was increased to 400 Watts, and TiN was reactively sputtered for 10 min.

Darocur^{®} 4265 Photoinitiator: a mixture of 50% of 2-hydroxy-2-methyl-1-phenyl-propan-1-one and 50% of 2,4,6-trimethylbenzoyldiphenyl-phosphine oxide, sold by CIBA Specialty Chemicals.

UV 9380C Photoinitiator: bis(dodecylphenyl)iodonium hexafluoroantimonate, sold by GE Toshiba Silicones.

Irgacure® 819 Photoinitiator: bis(2,4,6-trimethylbenzoyl)phenylphosphine oxide, sold by Ciba Specialty Chemicals.

Pfaltz & Bauer T17775 Photoinitiator: A solution of 50% of triarylsulfonium hexafluoroantimonate salts in propylene carbonate, sold by Pfaltz & Bauer (Waterbury, CT).

### Example 1

A hydrogensilsesquioxane resin (26.68 g) having the formula (HSiO_{3/2}) and a weight-average molecular weight of 7,100,70 mL of toluene, and 10 µL (23% w/w platinum) of a solution of platinum(0)-1,3-divinyl-1,1,3,3-tetramethyldisiloxane complex in 1,3-divinyl-1,1,3,3-tetramethyldisiloxane were combined in a flask and heated to 80 °C. Allyl glycidyl ether (48.4 g) was then added drop-wise to the mixture over a period of about 1 h. After completion of the addition, the mixture was allowed to cool to room temperature. Toluene and excess allyl glycidyl ether were removed under reduced pressure at 40 °C using a rotary evaporator. The residue was placed under vacuum (1 Pa) at room temperature overnight to give a silicone resin having the formula: 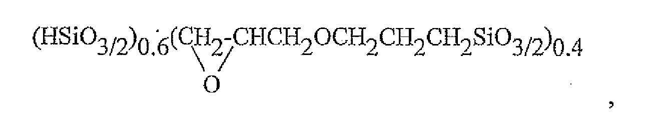 as determined by ²⁹Si NMR and ¹³C NMR, and a weight-average molecular weight of 23,400.

### Example 2

Concentrated hydrochloric acid (37%, 600 g), 1020 g of toluene, and 3.0 g of octylsulfonic acid sodium salt monohydrate were combined in a flask. A solution consisting of 90.75 g (0.67 mol) of trichlorosilane, 100.15 g (0.67 mol) of methyltrichlorosilane, and 6.14 g (0.038 mol) of trichlorovinylsilane was added drop-wise to the mixture over a period of abut 1 h. The mixture was stirred at room temperature for 4 h, after which time the aqueous layer was removed. The resulting organic layer was washed with 100 mL of 45% sulfonic acid (two times) and with 250 mL of deionized water (10 times). The solution was dried over magnesium sulfate and passed through a sintered glass filter. Toluene was removed under reduced pressure at 30 °C using a rotary evaporator. The residue was placed under vacuum (1 Pa) at room temperature overnight to give a silicone resin having the formula:

(HSiO_{3/2})_{0.485}(CH₃SiO_{3/2})_{0.485}(CH₂=CHSiO_{3/2})_{0.03},

as determined by ²⁹Si NMR and ¹³C NMR, and a weight-average molecular weight of 11,600.

### Example 3

Toluene (967 g), 596.04 g (2.40 mol) of [3-(methacryloyloxy)propyl)]-trimethoxysilane, 855.84 g (4.80 mol) of methyltriethoxysilane, 28.8 mol of water, 10.6 g of tetramethylammonium hydroxide solution (25% aqueous), 2400 g of methanol, and 0.664 g of 2,6-di-tert-butyl-4-methylphenol were combined in a flask. The mixture was stirred and heated at reflux for 2 h. Solvent (7330 g) was removed by distillation using a Dean-Stark trap. During the distillation toluene was added to the mixture to maintain a constant resin concentration. The temperature of the mixture was slowly increased to about 110 °C during about 1 h. The mixture was then allowed to cool to room temperature. Acetic acid (3.4 mL) was then added drop-wise to the stirred mixture over a period 1 h. The mixture was washed with 1,000 mL of deionized water (ten times) and then filtered. Toluene was removed under reduced pressure at 40 °C using a rotary evaporator. The residue was placed under vacuum (1 Pa) at room temperature for 3 h to give a silicone resin having the formula:

(CH₃SiO_{3/2})_{0.67}(CH₂=C(CH₃)C(=O)OCH₂CH₂CH₂SiO_{3/2})_{0.33},

as determined by ²⁹Si NMR and ¹³C NMR, and weight-average molecular weight of 12,600.

### Example 4

Toluene (100 g), 27.39 g (0.24 mol) of allyl glycidyl ether, and 50 mg (24.5% platinum) of a solution of platinum(0)-1,3-divinyl-1,1,3,3-tetramethyldisiloxane complex in 1,3-divinyl-1,1,3,3-tetramethyldisiloxane were combined under nitrogen in a flask equipped with a condenser, thermometer, and magnetic stir bar. A hydrogensilsesquioxane resin (0.258 mol) having the formula (HSiO_{3/2}) and a weight-average molecular weight of 12,000, was slowly added to mixture. Upon completion of the addition, the mixture was heated at reflux and the progress of the reaction was monitored by periodically withdrawing an aliquot of the mixture for analysis by gas chromatography. After 2 h, the mixture was allowed to cool to room temperature and toluene and excess allyl glycidyl ether were removed under reduced pressure at 40 °C using a rotary evaporator. The residue was placed under vacuum (1 Pa) at room temperature overnight to give a silicone resin having the formula: 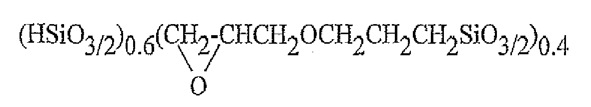 as determined by ²⁹Si NMR and ¹³C NMR, and a weight-average molecular weight of 8,000.

### Example 5

Toluene (47 g), 27.39 g (0.24 mol) of allyl glycidyl ether, and 50 mg (24.5% platinum) of a solution of platinum(0)-1,3-divinyl-1,1,3,3-tetramethyldisiloxane complex in 1,3-divinyl-1,1,3,3-tetramethyldisiloxane were combined under nitrogen in a flask equipped with a condenser, thermometer, and magnetic stir bar. A hydrogensilsesquioxane resin (0.258 mol) having the formula (HSiO_{3/2}) and a weight-average molecular weight of 2,500, was slowly added to mixture. Upon completion of the addition, the mixture was heated at reflux and the progress of the reaction was monitored by periodically withdrawing an aliquot of the mixture for analysis by gas chromatography. After 2 h, the mixture was allowed to cool to room temperature and toluene and excess allyl glycidyl ether were removed under reduced pressure at 40 °C using a rotary evaporator. The residue was placed under vacuum (1 Pa) at room temperature overnight to give a silicone resin having the formula; 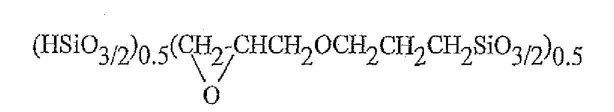 as determined by ²⁹Si NMR and ¹³C NMR, and a weight-average molecular weight of 9,000.

### Example 6

Toluene (30 g), 11.41g (0.1 mol) of allyl glycidyl ether, and 30 mg (24.5% platinum) of a solution of platinum(0)-1,3-divinyl-1,1,3,3-tetramethyldisiloxane complex in 1,3-divinyl-1,1,3,3-tetramethyldisiloxane were combined under nitrogen in a flask equipped with a condenser, thermometer, and magnetic stir bar. A hydrogenmethylsilsesquioxane resin (0.1 mol) having the formula (HSiO_{3/2})_{0.6}(MeSiO_{3/2})_{0.4} and a weight-average molecular weight of 18,000, was slowly added to the mixture. Upon completion of the addition, the mixture was heated at reflux and the progress of the reaction was monitored by periodically withdrawing an aliquot of the mixture for analysis by gas chromatography. After 5 h, the mixture was allowed to cool to room temperature and toluene and excess allyl glycidyl ether were removed under reduced pressure at 40 °C using a rotary evaporator. The residue was placed under vacuum (1 Pa) at room temperature overnight to give a silicone resin having the formula: 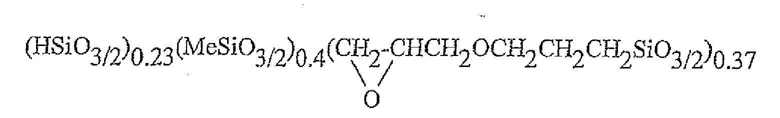 as determined by ²⁹Si NMR and ¹³C NMR, and a weight-average molecular weight of 6,000.

### Example 7

A solution (5 mL) consisting of 25% of the silicone resin of Example 1 and 5% of UV 9380C Photoinitiator in methyl isobutyl ketone was passed through a 0.2 µm filter. About 2 mL of the filtrate was spin-coated (2000 rpm for 20 seconds) on a 100-mm diameter silicon wafer to form a film having a thickness of about 1 µm. The film was exposed to ∼ 1 J/cm² of UV radiation at 450 W/in. using a Fusion UV Light System equipped with a mercury H-bulb (200-320 nm).

### Example 8

A solution (5 mL) consisting of 22% of the silicone resin of Example 2 and 10% of Darocur® 4265 Photoinitiator in methyl isobutyl ketone was passed through a 0.2 µm filter. About 2 mL of the filtrate was spin-coated (2000 rpm for 20 seconds) on a 100-mm diameter silicon wafer to form a film having a thickness of about 1 µm. The film was exposed to ∼ 1 J/cm² of UV radiation at 450 W/in. using a Fusion UV Light System equipped with both a mercury H-bulb (200-320 nm) and D-bulb (350-440 nm). The coated wafer was then heated on a hotplate at about 150 °C for 60 minutes.

### Example 9

A solution (5 mL) consisting of 30% of the silicone resin of Example 3 and 10% of Irgacure® 819 Photoinitiator in propylene glycol methyl ether acetate was passed through a 0.2 µm filter. About 2 mL of the filtrate was spin-coated (2,000 rpm for 20 seconds) on a 100-mm diameter pre-treated silicon wafer to form a coating having a thickness of about 1 µm. (The silicon wafer had been treated prior to deposition of the coating with oxygen plasma for 1 minute at a pressure of 0.15 Torr (20 Pa) and RF power of 100 W). The coating was exposed to ∼ 1 J/cm² of UV radiation at 450 W/in. using a Fusion UV Light System equipped with a mercury H-bulb (200-320 nm).

### Example 10

A solution (5 mL) consisting of 30% of the silicone resin of Example 1 and 10% of Pfaltz & Bauer T17775 Photoinitiator in propylene glycol methyl ether acetate was passed through a 0.2 µm filter. About 2 mL of the filtrate was spin-coated (2,000 rpm for 20 seconds) on a 100-mm diameter pre-treated silicon wafer to form a coating having a thickness of about 1 µm. (The silicon wafer had been treated prior to deposition of the coating with oxygen plasma for 1 minute at a pressure of 0.15 Torr (20 Pa) and RF power of 100 W). The coating was exposed to ∼ 1 J/cm² of UV radiation using a Quintel Mask Aligner equipped with a mercury bulb (300-400 nm). The coated wafer was then heated on a hotplate at about 150 °C for 60 minutes.

### Examples 11-16

In each of Examples 11-16, the following coated substrates were prepared using the process conditions shown in Table 1:
Example 11: Silicon/SiCOH(1.9)
Example 12: Silicon/IFL3
Example 13: Silicon/SiC/SiCOH(1.5)/SiCOH(1.9)
Example 14: Silicon/SiC/SiCOH(1.5)/SiCOH(1.9)/SiC/SiCOH(1.5)/SiCOH(1.9)
Example 15: Silicon/SiCOH(1.9)/IFL3/SiC/SiCOH(1.5)/SiCOH(1.9)
Example 16: Silicon/SiCOH(1.9)/IFL3/SiC/SiCOH(1.5)/SiCOH(1.9)/TiN/SiC/SiCOH(1.5)/SiCOH(1.9)
where Silicon refers to a 100-mm diameter silicon wafer, IFL3 refers to an interfacial layer comprising a cured product of the silicone resin of Example 3 (prepared as described in Example 9), SiCOH(1.9) refers to a layer of amorphous hydrogenated silicon oxycarbide having a density of 1.9 g/cm³, SiC refers to a layer of silicon carbide having a density of 1.85 g/cm³, SiCOH(1.5) refers to a layer of amorphous hydrogenated silicon oxycarbide having a density of 1.5 g/cm³, and TiN refers to a layer of titanium nitride. The properties of the coated substrates are shown in Table 1.

**Table 1**

| Ex. | Type of Layer | Process Parameters | | | | | | Film Properties | | | |
|---|---|---|---|---|---|---|---|---|---|---|---|
| | | Gas Flow Rate, seem | | | Power, W | | DR, nm/min. | T, nm | RI | Stress, MPa | *d*, g/cm³ |
| | | TMS | Ar | O₂ | LF | RF | | | | | |
| 11 | SiCOH(1.9) | 40 | 800 | 20 | 85 | 600 | 267 | 200 | 2.4 | -70.35 | 1.8 |
| 12 | IFL3 | na | na | na | na | na | na | 1200 | 1.5 | -0.1 | - |
| 13 | SiC | 40 | 160 | 0 | 20 | 650 | 133 | 100 | 2.4 | | 1.85 |
| | SiCOH (1.5) | 30 | 180 | 25 | 15 | 250 | 133 | 400 | 1.5 | | 1.5 |
| | SiCOH (1.9) | 40 | 800 | 20 | 85 | 600 | 194 | 500 | 2.0 | -6.75 | 1.9 |
| 14 | SiC | 40 | 160 | 0 | 20 | 650 | 133 | 100 | 2.4 | | 1.85 |
| | SiCOH (1.5) | 30 | 180 | 25 | 15 | 250 | 133 | 400 | 1.5 | | 1.5 |
| | SiCOH (1.9) | 40 | 800 | 20 | 85 | 600 | 194 | 500 | 2.0 | | 1.9 |
| | SiC | 40 | 160 | 0 | 20 | 650 | 133 | 100 | 2.4 | | 1.85 |
| | SiCOH(1.5) | 30 | 180 | 25 | 15 | 250 | 133 | 400 | 1.5 | | 1.5 |
| | SiCOH (1.9) | 40 | 800 | 20 | 85 | 600 | 194 | 500 | 2.0 | -3.15 | 1.9 |
| 15 | SiCOH(1.9) | 40 | 800 | 20 | 85 | 600 | 267 | 200 | 2.4 | | 1.8 |
| | IFL3 | na | na | na | na | na | na | 1200 | 1.5 | | - |
| | SiC | 40 | 160 | 0 | 20 | 650 | 133 | 100 | 2.4 | | 1.85 |
| | SiCOH(1.5) | 30 | 180 | 25 | 15 | 250 | 133 | 400 | 1.5 | | 1.5 |
| | SiCOH(1.9) | 40 | 800 | 20 | 85 | 600 | 194 | 500 | 2.0 | 4.9 | 1.9 |
| 16 | SiCOH(1.9) | 40 | 800 | 20 | 85 | 600 | 267 | 200 | 2.4 | | 1.8 |
| | IFL3 | na | na | na | na | na | na | 1200 | 1.5 | | - |
| | SiC | 40 | 160 | 0 | 20 | 650 | 133 | 100 | 2.4 | | 1.85 |
| | SiCOH(1.5) | 30 | 180 | 25 | 15 | 250 | 133 | 400 | 1.5 | | 1.5 |
| | SiCOH(1.9) | 40 | 800 | 20 | 85 | 600 | 194 | 500 | 2.0 | | 1.9 |
| | TiN | na | na | na | na | na | na | 200 | - | | - |
| | SiC | 40 | 160 | 0 | 20 | 650 | 133 | 100 | 2.4 | | 1.85 |
| | SiCOH(1.5) | 30 | 180 | 25 | 15 | 250 | 133 | 400 | 1.5 | | 1.5 |
| | SiCOH(1.9) | 40 | 800 | 20 | 85 | 600 | 194 | 500 | 2.0 | 2.7 | 1.9 |

| | | | | | | | | | | | |
|---|---|---|---|---|---|---|---|---|---|---|---|
| TMS is trimethylsilane, LF is low frequency, RF is radiofrequency, DR is deposition rate, T is average thickness, RI is refractive index, Stress refers to compressive stress of all layers on a silicon wafer, d is density, "na" means not applicable, and "-" denotes property not measured. | | | | | | | | | | | |

### Examples 17-23

In each of Examples 17-22, coated substrates were prepared as described in Examples 11-16, except the silicon wafer was replaced with a 150-mm diameter Corning® 1737 glass wafer. The percent transmittance of the coated glass substrates are shown in Table 2. In Example 23, the percent transmittance of an uncoated glass wafer was measured for comparison.

**Table 2**

| Ex. | %T/Wavelength | | | | |
|---|---|---|---|---|---|
| | 430 nm | 470 nm | 530 nm | 550 nm | 650 nm |
| 17 | 91.55 | 92.23 | 90.22 | 89.70 | 89.92 |
| 18 | 91.42 | 91.53 | 91.82 | 92.61 | 91.93 |
| 19 | 57.48 | 71.57 | 80.17 | 86.63 | 86.80 |
| 20 | 49.52 | 67.83 | 81.03 | 80.42 | 80.83 |
| 21 | 58.66 | 65.52 | 71.23 | 79.56 | 87.44 |
| 22 | 5.02 | 6.10 | 9.58 | 7.51 | 5.43 |
| 23 | 90.26 | 90.43 | 90.52 | 90.60 | 90.68 |

| | | | | | |
|---|---|---|---|---|---|
| %T refers to percent transmittance of the coated glass wafer measured at the specified wavelength. | | | | | |

### Examples 24-30

In each of Examples 24-29, coated substrates were prepared as described in Examples 17-22, except calcium was first deposited on each glass wafer to a thickness of 100 nm by thermal evaporation (upward technique) through a shadow mask having a 3 x 3 array of 1-in. square apertures, as described above.

The barrier and interfacial coatings of Examples 17-22 were then deposited on the calcium-coated glass wafer. The wafers were exposed to 30-50% RH at 20 °C and the percent transmittance of the calcium squares at 550 nm on each wafer was measured at regular intervals. Upon exposure to moisture and oxygen, the metallic calcium reacted over time to form an increasingly transparent layer of calcium oxides, hydroxides, and/or salts. The time in hours corresponding to a 10% and 30% increase in percent transmittance for each coated substrate is shown in Table 3. In example 30, the percent transmittance of a glass wafer coated only with calcium was measured for comparison.

**Table 3**

| Ex. | Time to 10% Increase in %T (h) | Time to 30% Increase in %T (h) |
|---|---|---|
| 24 | 8 | <24 |
| 25 | 0.27 | 0.4 |
| 26 | 96 | 240 |
| 27 | 576 | 12960 |
| 28 | 648 | 1584 |
| 29 | - | - |
| 30 | 0.02 | 0.03 |

| | | |
|---|---|---|
| "-" denotes property not measured. | | |

The present invention includes the following embodiments:
A coated substrate, comprising:
a substrate;
an inorganic barrier coating on the substrate; and
an interfacial coating on the inorganic barrier coating, wherein the interfacial coating comprises a cured product of a silicone resin having the formula (R¹R³₂SiO_{1/2})ₐ(R³₂SiO_{2/2})_{b}(R³SiO_{3/2})_{c}(SiO_{4/2})_{d} (I), wherein each R¹ is independently C₁ to C₁₀ hydrocarbyl, C₁ to C₁₀ halogen-substituted hydrocarbyl, or -OR² wherein R² is C₁ to C₁₀ hydrocarbyl or C₁ to Cj₁₀ halogen-substituted hydrocarbyl, each R³ is independently R¹, -H, or a radiation-sensitive group, a is from 0 to 0.95, b is from 0 to 0.95, c is from 0 to 1, d is from 0 to 0.9, c+d = 0.1 to 1, and a+b+c+d=1, provided the silicone resin has an average of at least two silicon-bonded radiation-sensitive groups per molecule.

The coated substrate according to the invention, wherein the substrate is an electronic device.

The coated substrate according to the invention, wherein the subscript c in the formula of the silicone resin has a value of 1.

The coated substrate according to the invention, wherein the radiation-sensitive group is selected from acryloyloxyalkyl, substituted acryloyloxyalkyl, an alkenyl ether group, alkenyl, and an epoxy-substituted organic group.

The coated substrate according to the invention, further comprising an additional inorganic barrier coating on the interfacial coating.

The coated substrate according to the invention, further comprising at least two alternating inorganic barrier and interfacial coatings on the interfacial coating, wherein each alternating interfacial coating comprises a cured product of a silicone resin having the formula (I).

A method of preparing a coated substrate, the method comprising the steps of:
forming an inorganic barrier coating on a substrate; and
forming an interfacial coating on the inorganic barrier coating, wherein the interfacial coating comprises a cured product of a silicone resin having the formula (R¹R³₂SiO_{1/2})ₐ(R³₂SiO_{2/2})_{b}(R³SiO_{3/2})_{c}(SiO_{4/2})_{d} (I), wherein each R¹ is independently C₁ to C₁₀ hydrocarbyl, C₁ to C₁₀ halogen-substituted hydrocarbyl, or -OR², wherein R² is C₁ to C₁₀ hydrocarbyl or C₁ to C₁₀ halogen-substituted hydrocarbyl, each R³ is independently R¹, -H, or a radiation-sensitive group, a is from 0 to 0.95, b is from 0 to 0.95, c is from 0 to 1, d is from 0 to 0.9, c+d = 0.1 to 1, and a+b+c+d=1, provided the silicone resin has an average of at least two silicon-bonded radiation-sensitive groups per molecule.

## Claims

1. A coated substrate, comprising:
a substrate;
an interfacial coating on the substrate, wherein the interfacial coating comprises a cured product of a silicone resin having the formula (R¹R³₂SiO_{1/2})ₐ(R³₂SiO_{2/2})_{b}(R³SiO_{3/2})_{c}SiO_{4/2})_{d} (I), wherein each R¹ is independently C₁ to C₁₀ hydrocarbyl, C₁ to C₁₀ halogen-substituted hydrocarbyl, or -OR², wherein R² is C₁ to C₁₀ hydrocarbyl or C₁ to C₁₀ halogen-substituted hydrocarbyl, each R³ is independently R¹, -H, or a radiation-sensitive group, a is from 0 to 0.95, b is from 0 to 0.95, c is from 0 to 1, d is from 0 to 0.9, c+d = 0.1 to 1, and a+b+c+d=1, provided the silicone resin has an average of at least two silicon-bonded radiation-sensitive groups per molecule; and
an inorganic barrier coating on the interfacial coating.

2. The coated substrate according to claim 1, wherein the substrate is an electronic device.

3. The coated substrate according to claim 1, wherein the subscript c in the formula of the silicone resin has a value of 1.

4. The coated substrate according to claim 1, wherein the radiation-sensitive group is selected from acryloyloxyalkyl, substituted acryloyloxyalkyl, an alkenyl ether group, alkenyl, and an epoxy-substituted organic group.

5. The coated substrate according to claim 1, further comprising an additional interfacial coating on the inorganic barrier coating, wherein the additional interfacial coating comprises a cured product of a silicone resin having the formula (I).

6. The coated substrate according to claim 1, further comprising at least two alternating interfacial and inorganic barrier coatings on the inorganic barrier coating, wherein each alternating interfacial coating comprises a cured product of a silicone resin having the formula (I).

7. A method of preparing a coated substrate, the method comprising the steps of:
forming an interfacial coating on a substrate, wherein the interfacial coating comprises a cured product of a silicone resin having the formula (R¹R³₂SiO_{1/2})ₐ(R³₂SiO_{2/2})_{b}(R³SiO_{3/2})_{c}SiO_{4/2})_{d} (I), wherein each R¹ is independently C₁ to C₁₀ hydrocarbyl, C₁ to C₁₀ halogen-substituted hydrocarbyl, or -OR², wherein R² is C₁ to C₁₀ hydrocarbyl or C₁ to C₁₀ halogen-substituted hydrocarbyl, each R³ is independently R¹, -H, or a radiation-sensitive group, a is from 0 to 0.95, b is from 0 to 0.95, c is from 0 to 1, d is from 0 to 0.9, c+d = 0.1 to 1, and a+b+c+d=1, provided the silicone resin has an average of at least two silicon-bonded radiation-sensitive groups per molecule; and
forming an inorganic barrier coating on the interfacial coating.
